# EUROPEAN PATENT SPECIFICATION

(11) **EP 4 293 374 B1**
(45) Date of publication and mention of the grant of the patent: **30.10.2024**
(21) Application number: 23176512.4
(22) Date of filing: 31.05.2023
(51) Int. Cl.: G01R 31/3835, G01R 31/396

(54) **BATTERY MONITORING TECHNIQUES**
BATTERIEÜBERWACHUNGSTECHNIKEN
TECHNIQUES DE SURVEILLANCE DE BATTERIE

(30) Priority: 15.06.2022 US 202263352426 P; 22.05.2023 US 202318200446
(43) Date of publication of application: 20.12.2023
(73) Proprietor: Analog Devices International Unlimited Company, Limerick (IE)
(72) Inventor: LYDEN, Colin G., Baltimore (IE); DALY, Brendan M., Farnanes P14 PN36 (IE); O'BRIEN, Michael W., Munster P36 FP65 (IE)
(74) Representative: Yang, Shu

(56) References cited:
- US-A1- 2018 164 363
- US-B1- 11 131 717
- US-B1- 11 217 833
- SORES MILAN ATTILA ET AL: "Overview of possible methods of determining self-discharge", 2020 IEEE INTERNATIONAL CONFERENCE ON ENVIRONMENT AND ELECTRICAL ENGINEERING AND 2020 IEEE INDUSTRIAL AND COMMERCIAL POWER SYSTEMS EUROPE (EEEIC / I&CPS EUROPE), IEEE, 9 June 2020 (2020-06-09), pages 1 - 5, XP033801838, DOI: 10.1109/EEEIC/ICPSEUROPE49358.2020.9160787

## Description

### CLAIM OF PRIORITY

This application claims the benefit of priority of U.S. Provisional Patent Application Serial Number 63/352,426, titled "BATTERY MONITORING TECHNIQUES" to Colin G. Lyden et al., filed on June 15, 2022 and of U.S Non-Provisional Patent Application Serial Number 18/200,446, titled "BATTERY MONITORING TECHNIQUES" to Colin G. Lyden et al., filed on May 22, 2023.

### FIELD OF THE DISCLOSURE

This document pertains generally, but not by way of limitation, to battery monitoring techniques.

### BACKGROUND

Electrified machines, such as electric vehicles, are powered by batteries instead of an engine to power or actuate an electric drive motor or other drive train system of the machine. A battery pack may include one or more battery modules, and a battery module may include one or more battery cells. Battery modules may include a battery cell monitoring circuit to monitor, among other things, a voltage of the battery cells in the battery module.

Individual battery cells may be connected in series to provide a battery stack having a desired output voltage. A large number of cells may be connected in series such that the total potential difference developed across the battery stack is on the order of 150-600 volts, for example.

In general, it may be desirable to monitor the terminal voltage because a low terminal voltage may indicate a discharged condition. The terminal voltage is a direct measurement of the DC voltage at the cell terminals.

US 2018/164363 A1 discloses self-discharge leakage current measurements to determine a self-discharge leakage current characteristic of a battery cell.

### SUMMARY OF THE DISCLOSURE

The invention is set out in the appended set of claims.

This disclosure is directed to various techniques for determining self-discharge rates of one or more battery cells, such as by determining a current leakage of the battery cell(s). The techniques may improve the effective ADC linearity. An example of a technique may calculate the average time when each ADC digital code is observed, such as for a given battery cell or battery module, which allows the battery cell discharge rate to be estimated from the interval between the average time observed for neighboring, e.g., adjacent, digital codes. This approach allows the self-discharge rate of a battery cell to be calculated with high resolution even when the total cell voltage excursion is only a few LSBs.

In some aspects, this disclosure is directed to a battery management system configured to determine a self-discharge rate of at least one battery cell, the battery management system comprising: an analog-to-digital converter (ADC) circuit coupled to the at least one battery cell and configured to receive an analog input signal representing a voltage of the at least one battery cell and generate digital codes representing the analog input signal at corresponding time intervals; and a processor configured to: receive the digital codes; determine a length of time at which corresponding ones of the digital codes remain; and determine the self-discharge rate of the at least one battery cell using the determined length of time.

In some aspects, this disclosure is directed to a method of determining a self-discharge rate of at least one battery cell coupled to an analog-to-digital converter (ADC) circuit, wherein the ADC circuit is configured to receive an analog input signal representing a voltage of the at least one battery cell and generate digital codes representing the analog input signal at corresponding time intervals, the method comprising: receiving the digital codes; determining a length of time at which corresponding ones of the digital codes remain; and determining the self-discharge rate of the at least one battery cell using the determined length of time.

In some aspects, this disclosure is directed to a battery management system configured to determine a self-discharge rate of at least one battery cell, the battery management system comprising: an analog-to-digital converter (ADC) circuit coupled to the at least one battery cell and configured to receive an analog input signal representing a voltage of the at least one battery cell and generate digital codes representing the analog input signal at corresponding time intervals; a processor configured to: receive the digital codes; determine a length of time at which corresponding ones of the digital codes remain; and determine the self-discharge rate of the at least one battery cell using the determined length of time; and a resistor coupled in series with a switching element, the resistor and switching element coupled in parallel across one of the battery cells, wherein the processor is configured to control operation of the switching element to increase a rate at which the battery cell discharges.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 is a simplified block diagram of an example of a system that may implement various techniques of this disclosure.
FIG. 2 is a graph that depicts cell voltage waveforms for self-discharge rate determination.
FIG. 3 is a graph that depicts top-of-waveform envelopes with time averaging for the battery cells in FIG. 2.
FIG. 4 is a graph that depicts the plots in FIG. 3 after using the mean or median time at which each digital code was received.
FIG. 5 is a graph that depicts the plots in FIG. 4 after using an outlier rejection technique.
FIG. 6 is a flow diagram of an example of a method of determining a self-discharge rate of at least one battery cell coupled to an analog-to-digital converter (ADC) circuit, where the ADC circuit is configured to receive an analog input signal representing a voltage of the at least one battery cell and generate digital codes representing the analog input signal at corresponding time intervals.

### DETAILED DESCRIPTION

Electric vehicles have been gaining immense popularity. One factor facilitating adoption of electric vehicles has been improvement in battery management. The battery modules may be associated with a battery management system (BMS) that is configured to protect the battery modules from damage by controlling, such as by limiting or regulating, the power drawn from the modules, such as during operation of an electrical vehicle.

In some examples, the BMS can include control circuitry that limits the amount of current that is drawn from a battery module by the drive train system of an electric vehicle. As an example, the control circuitry can interrupt the current drawn from the battery module when current exceeds a safe operating range of one or more components of the system. Using a BMS, electric vehicles may monitor battery levels, such as individual cell voltages or battery module voltages, which in turn may operate the vehicle more reliably and efficiently.

As an example, automotive original equipment manufacturers (OEMs) are interested in monitoring battery cell self-discharge, such as in a manufacturing facility before installation into the electric vehicle and/or throughout the life of the batteries after installation into the electric vehicle. Self-discharge refers to a decrease in the stored charge of the battery where there is no connection between the electrodes of the battery and an external circuit.

A self-discharge rate of more than 2% of full capacity per month may be classified as a fault. The most direct indicator of self-discharge rate is the reduction in battery cell open circuit voltage (OCV) as the battery cell state of charge (SOC) is reduced, such as by leakage current. As the OCV versus SOC curve is designed to be very flat, even faulty levels of self-discharge may cause very slow changes in OCV. To ensure that the cumulative effect of any leakage on battery cell OCV is detectable, it is common to let the battery cells sit for up to two weeks in the factory. The present inventors have recognized a need to reduce the manufacturing delay, through faster detection of battery cell self-discharge.

Finite resolution of an analog-to-digital converter (ADC) circuit is one impediment to detecting small changes in battery cell OCV. The BMS may include one or more analog-to-digital converter (ADC) circuits to digitize a signal representing a battery cell voltage, for example. The ADC circuit may generate a digital code representing the magnitude of an input voltage, such as the battery cell voltage. The ADC circuit may operate bit-by-bit across all bit positions to determine the most significant bit (MSB) through the least significant bit (LSB) to generate a complete digital code that corresponds to the input voltage.

The currents available to act as stimulus for electric vehicle battery monitoring are small, and the corresponding voltage response of the battery cell is very small, typically of the order of the LSB of the available embedded ADC circuits of the BMS. An example of the unit ADC step size in an electric vehicle battery monitor is 100 microvolts (µV). That is, the LSB of an example of an ADC circuit may represent 100 µV. Therefore, the resolution of that example of an ADC circuit is 100 µV and thus the ADC circuit cannot discriminate voltage changes that are less than 100 µV.

One approach to determining a self-discharge rate of a battery cell is to measure the OCV at the start and the end of some specified interval, then divide the voltage difference by the time difference to calculate a slope. This approach may have problems if the expected change in OCV is of the same scale as the LSB of the ADC circuit. For instance, if the leakage causes the battery cell OCV to drop at 10µV/hour, then 10 hours of observation may be needed to detect that self-discharge, and 100 hours may be needed to determine the self-discharge with a resolution of 10% of reading. The present inventors have recognized a need to improve self-discharge rate determination techniques to allow the battery cell discharge rate to be calculated with high resolution even when the total battery cell voltage excursion is only a few LSBs.

This disclosure is directed to various techniques for determining self-discharge rates of one or more battery cells, such as by determining a current leakage of the battery cell(s). The techniques may improve the effective ADC linearity. An example of a technique may calculate the average time when each ADC digital code is observed, such as for a given battery cell or battery module, which allows the battery cell discharge rate to be estimated from the interval between the average time observed for neighboring, e.g., adjacent, digital codes. This approach allows the self-discharge rate of a battery cell to be calculated with high resolution even when the total cell voltage excursion is only a few LSBs.

Another example of a technique of this disclosure draws a controlled bleed current, such as from the battery cell or battery module, while self-discharge is being monitored, to ensure that the battery cell or battery module voltage changes by many LSBs in the measurement period. The resulting diversity in ADC digital output codes means that the impact of transfer function errors associated with any particular code can be minimized by mean or median filtering. In some examples, the filtering may be implemented using machine learning techniques such as neural networks or support vector machines. A machine learning model may be trained using a range of example measurements of input codes and corresponding desired outputs. As an example, the model may be trained in a laboratory in advance of system use in the field.

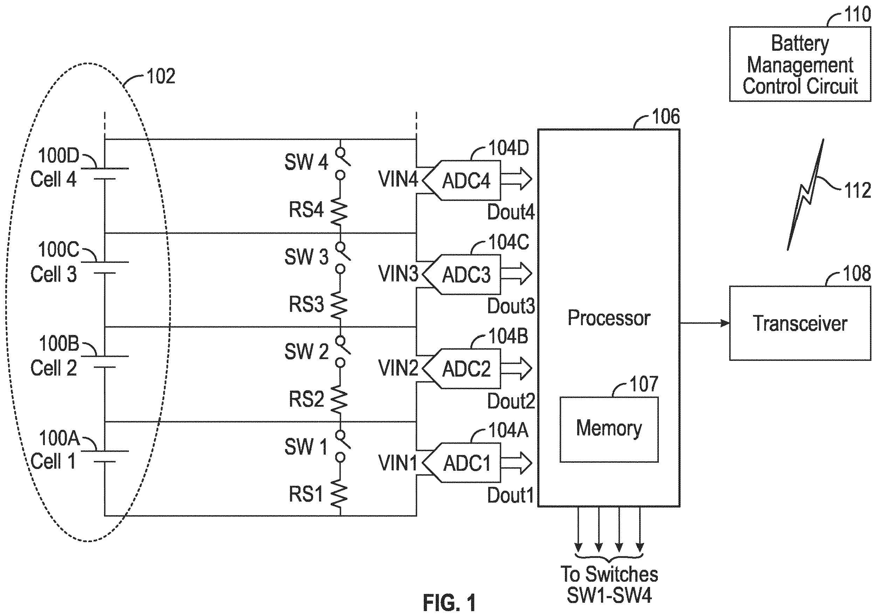

FIG. 1 is a simplified block diagram of an example of a system that may implement various techniques of this disclosure. In FIG. 1, one or more battery cells 100A-100D may be coupled in series to form a battery module 102. In the example shown, the battery cells 100A-100D may be coupled to corresponding ADC circuits 104A-104D. In other examples, the battery cells 100A-100D may be coupled to multiplexer circuit, and the multiplexer circuit may be coupled to a single ADC circuit.

As an example, an ADC circuit may be coupled to one or more battery cells and configured to receive an analog input signal representing a corresponding voltage of the battery cell(s) and generate digital codes representing the analog input signal at corresponding time intervals. For example, ADC circuit 104A may receive an analog input signal VIN1 that represents the corresponding voltage of the battery cell 100A and generate a digital output including digital codes DOUT1 that represents the analog input signal VIN1 at corresponding time intervals.

A processor circuit 106 having a memory circuit 107 may be coupled to receive the output of the ADC circuits 104A-104D (or the output of a single ADC circuit in a multiplexed configuration). The processor circuit 106 may be coupled to a transceiver circuit 108, e.g., wireless radio. The transceiver circuit 108 may wirelessly communicate with a battery management control circuit 110, as indicated by lightning bolt 112. The battery management control circuit 110 may receive information from the processor circuit 106 and operate to protect the battery modules from damage by controlling, such as by limiting or regulating, the power drawn from the modules, such as during operation of an electrical vehicle.

The ADC circuits 104A-104D, the processor circuit 106, the transceiver circuit 108, and the battery management control circuit 110 may form at least a portion of a battery management system (BMS) that may perform various techniques described in this disclosure. As described in more detail below, a processor, such as the processor circuit 106, may be configured to, among other things, receive digital codes generated by an ADC circuit, such as the ADC circuit 104A, determine a length of time at which corresponding ones of the digital codes remain (or linger), and determine a self-discharge rate of one or more corresponding battery cells, such as the battery cell 100A, using the determined length of time.

In some examples, the battery management system may include a resistor coupled in series with a switching element, where the resistor and switching element are coupled in parallel across one of the battery cells. For example, resistor RS 1 may be coupled in series with switching element SW1, where the resistor RS1 and the switching element SW1 are coupled in parallel across the battery cell 100A. In some examples, the other battery cells 100B-100D may be associated with similar resistors RS2-RS4 and switching elements SW2-SW4. A processor, such the processor circuit 106, may be configured to control operation of a switching element to increase a rate at which the corresponding battery cell discharges. For example, the processor may control, using a pulsed pattern, the switching element, e.g., SW1, to switch between an open state and a closed state. The pulsed pattern may be generated using pulse width modulation or pulse dense modulation techniques, for example. Controlling the resistor and switching element combination may reduce the time needed to test the battery cells.

One or more of the ADC circuits, such as the ADC circuits 104A-104D of FIG. 1, may suffer from non-idealities, such as non-linearity. In some cases, the non-idealities may be known at the time of manufacture, but are not corrected in the ADC. For example, there could be a range of codes for which the transfer function of the ADC is not ideal.

In some examples, information about the ADC non-linearity can be stored with the ADC or with the battery management control circuit 110. In some examples, the processor or the battery management control circuit can correct the calculated ADC cell voltage slopes based on the known non-linearity. As an example, certain regions of the ADC transfer function are recorded as having less reliable linearity, and cell voltage slopes that are based on such regions are discarded as unreliable. The information about ADC non-linearity may be determined as part of the ADC characterization in the ADC factory.

In some implementations, it can be advantageous to perform the techniques described above (such as linear regression techniques) on the battery cell side, such as by the processor circuit 106, with communication of the results over the air via the transceiver circuit 108 to the battery management control circuit 110. This can greatly reduce the amount of data transmitted over the air, compared to other implementations where every ADC sample is sent over the air, with calculations (such as the cell voltage slope) performed at the battery management control circuit 110.

In other examples, the processor circuit 106 may not have the capacity to perform these calculations. As such, it may be desirable for the battery management control circuit 110 to do so. The battery management control circuit 110 can be configured to, among other things, receive the digital codes, determine a length of time at which corresponding ones of the digital codes remain, and determine the self-discharge rate of the at least one battery cell using the determined length of time. The battery management control circuit 110 can further perform other techniques, such as the linear regression techniques, described in this disclosure.

Battery cell voltage depends on temperature, and a steadily changing cell temperature will change the cell voltage slope. In many cases, the battery cell temperature is available as an auxiliary measurement. The sensitivity of cell voltage to temperature is known to be a function of cell chemistry and the state of charge (SOC). In some examples, the processor circuit 106 or the battery management control circuit 110 can correct the calculated cell voltage slopes for changing cell temperatures based on sensitivity of cell voltage to temperature stored in a memory associated with the processor circuit 106 or the battery management control circuit 110. In this manner, the processor circuit 106 or the battery management control circuit 110 can determine temperature corrected cell voltages, which can then be processed to determine the self-discharge rates.

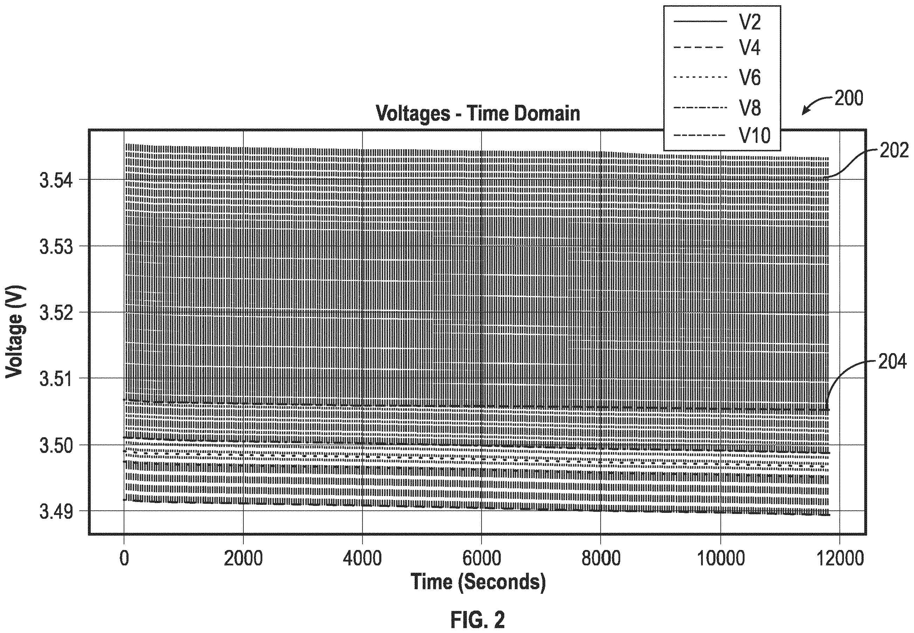

FIG. 2 is a graph that depicts cell voltage waveforms for self-discharge rate determination. The x-axis depicts time in seconds and the y-axis depicts the cell voltage in volts.

The graph 200 depicts the cell voltages for five (5) battery cells (V2, V4, V6, V8, and V10). In an example of an implementation, the cell voltages may be acquired by controlling corresponding switching elements, such as the switching elements SW1-SW4 in FIG. 1, using a pulsed pattern. As a non-limiting example, a processor may control the switching element such that every 40 seconds the switching element closes for 32 seconds and opens for 8 seconds. When a switching element associated with the battery cell V10 is open, the upper envelope 202 may be formed, and when the switching element is closed, the lower envelope 204 may be formed.

Either the upper envelope 202 or the lower envelope 204 may be used to determine the self-discharge rate of the battery cell V10, such as resulting from a leakage current. One voltage may be measured when its switching element is closed (first state), and another voltage when its switching element is open (second state). The techniques described below may be applied to either of those two states separately, or to the average voltage of the two states. This choice may be used to select the state with the most convenient time alignment.

By controlling the switching element, such as the switching element SW1 in FIG. 1, to place a resistor, such as the resistor RS1 in FIG. 1, in parallel with the battery cell, the battery cell may discharge at a faster rate, which may increase the number of digital codes generated by an ADC circuit, which may expedite the testing of the battery cell.

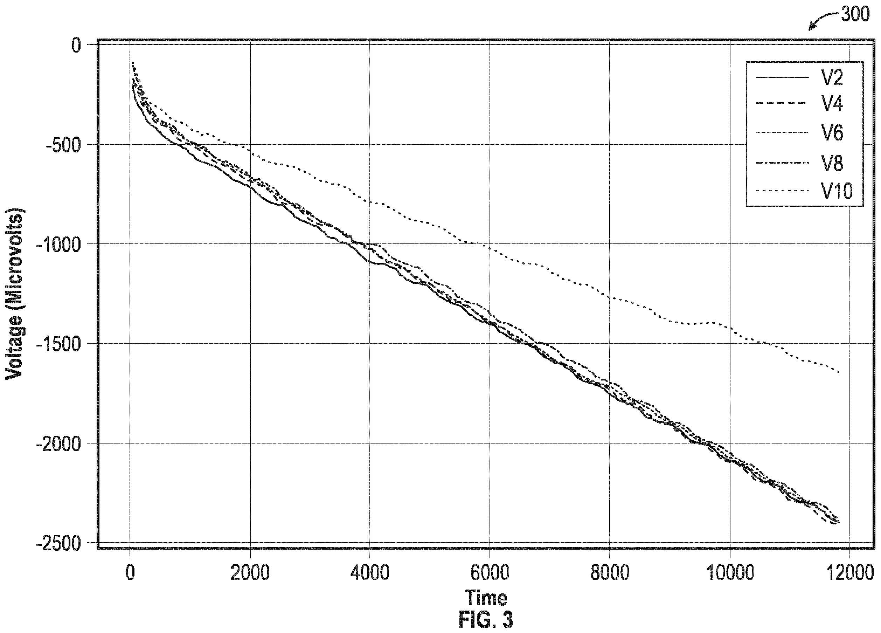

FIG. 3 is a graph that depicts top-of-waveform envelopes with time averaging for the battery cells in FIG. 2. The graph 300 depicts the cell voltages for the five (5) battery cells (V2, V4, V6, V8, and V10) of FIG. 2, in particular the top envelope waveforms. The x-axis depicts time in seconds and the y-axis depicts the cell voltage in microvolts. In FIG. 3, 1 LSB of a digital code equals 100 microvolts.

As seen in FIG. 3, as time increases, the cell voltages decrease as the battery cells discharge. The techniques of this disclosure may determine a self-discharge rate, such as caused by leakage current, of one or more battery cells. For example, various techniques of this disclosure may be used to measure how long each change in LSB takes, rather than measuring how many LSBs change in a fixed time period. Such an approach may provide significantly improved measurement resolution. For instance, if a leakage current causes a first battery cell to self-discharge at 1LSB every 10 hours, and a second battery cell to self-discharge discharge at 1LSB every 11 hours, then the leakage in the second battery cell is 10% higher than in the first battery cell, after only 11 hours.

As an example, the ADC circuit 104A of FIG. 1 may receive an analog input signal VIN1 that represents the corresponding voltage of the battery cell 100A of FIG. 1 and generate a digital output including digital codes DOUT1 that represents the analog input signal VIN1 at corresponding time intervals. The processor circuit 106 of FIG. 1 may receive the digital codes from the ADC circuit 104A and determine, for one or more of the digital codes, a length of time at which the corresponding digital codes remain or linger.

As a non-limiting example for the purposes of explanation only, assume the processor circuit 106 receives, at a first time, a first 4-bit digital code of 0111 from the ADC circuit 104A representing the voltage of the battery cell 100A of FIG. 1. As the battery cell 100A of FIG. 1 self-discharges, such as by leakage current, the voltage of the battery cell 100A will eventually decrease and the ADC circuit 104A will output a second 4-bit digital code of 0110, at a second time, to the processor circuit 106, which is a change (decrease) in 1 LSB. The processor circuit 106 may determine a length of time at which the first digital code remained or lingered, such as before the first digital code changed to the second digital code. For example, the processor circuit 106 may determine the difference between the first time and the second time. Then, the processor circuit 106 may determine the self-discharge rate of the battery cell using the determined length of time and the amount of change in the digital codes, which represents the voltage change. As a non-limiting example, the processor circuit 106 may determine a self-discharge rate of 1 LSB per 500 seconds.

FIG. 3 depicts significant staircasing aligned to the LSBs (flat at the LSB transition and steep at the midpoints). That is, the cell voltages of the battery cells V2-V10 depict a staircase pattern rather than a smooth ramp. The staircase pattern may be the result of 100 microvolt steps, which may be improved by using interpolation.

Time averaging, such as over two minutes, may be useful because the measured cell voltage may be moving due to a noisy ADC circuit. Time averaging may smooth away the ADC sampling noise. For example, the processor, such as the processor circuit 106 of FIG. 1, may be configured to perform, before determining the length of time at which corresponding ones of the digital codes remain, time averaging of the received digital codes to determine an average time at which corresponding ones of the digital codes were received.

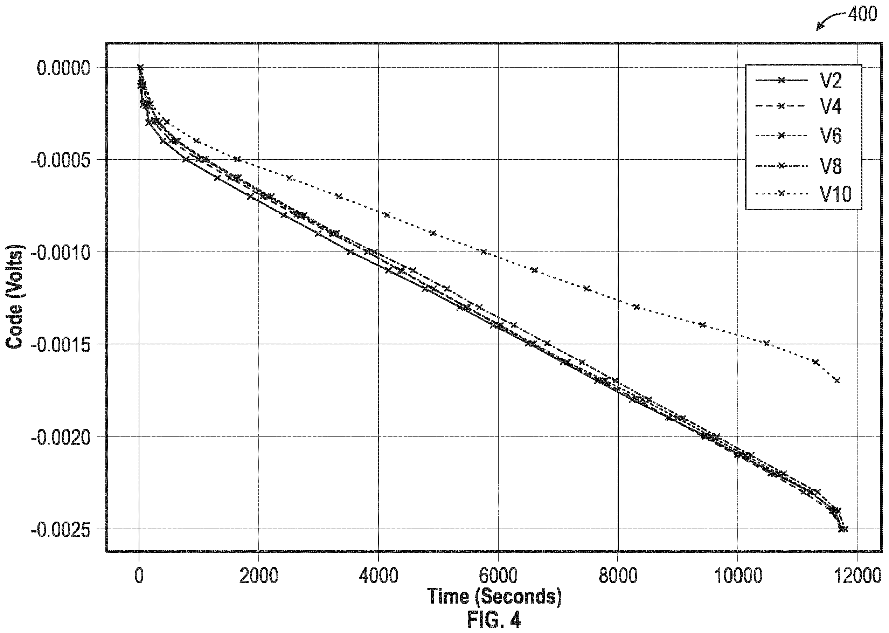

Noise in the cell voltage measurement system may be significant compared to the LSB size. An indicative magnitude of the noise in such systems is 50 microvolts (RMS) on each sample. Estimates of change in open circuit voltage (OCV) should desirably minimize this noise. In accordance with this disclosure, and as described below with respect to FIG. 4, one such technique is to calculate the mean or median time that each digital code is observed.

In other examples, the processor, such as the processor circuit 106 of FIG. 1, may be configured to perform, before determining the length of time at which corresponding ones of the digital codes remain, a linear regression technique, such as a least squares regression technique, to fit a line to the measured cell voltages to determine cell voltage slope. The slope of the line represents a self-discharge rate. For example, the processor can perform a linear regression technique on received digital codes representing the cell voltages of the battery cells V2-V10 in FIG. 3 and the determined lengths of time at which corresponding ones of the digital codes remain to determine a slope of the line.

FIG. 4 is a graph that depicts the plots in FIG. 3 after using the mean or median time at which each digital code was received. The graph 400 depicts the cell voltages for the five (5) battery cells (V2, V4, V6, V8, and V10) of FIG. 2. The x-axis depicts time in seconds and the y-axis depicts the digital code in volts.

Each point on a curve in FIG. 4 represents the mean or median time that the processor circuit 106 of FIG. 1 observed a particular digital code. For each digital code, the processor circuit 106 may add up the time when the processor 106 observed the digital code and then divide that time by the number of times the digital code was observed. In this manner, the processor circuit 106 may determine how long between a mean or median time that a digital code was observed and when the next digital code was observed, which is a measure of how fast the digital codes are being received and, as such, a measure of the discharge rate of a battery cell. As seen in FIG. 4, the staircase effect of FIG. 3 has been removed.

This mean or median time for each digital code may be used in the calculation of how long the LSB changes take, for example. For instance, if the mean (or median) time that a first 4-bit digital code of 0111 appeared was at 11:01 AM and the mean (or median) time that second 4-bit digital code of 0110 appeared was 11:21 AM, then the processor circuit 106 may determine that the digital codes are changing at a rate of 1LSB every 20 minutes.

To implement these techniques of FIG. 4, the processor circuit 106 may, for one or more digital codes, determine a mean or median time at which each digital code was received, and then determine the self-discharge rate of the battery cell(s) using the determined mean or median times.

As an alternative to the mean or median techniques described above, the processor 106 may determine the timing of the transition between adjacent digital codes. As an example, the processor circuit 106 may estimate a transition time from digital code N to digital code N+1 as the time when the output of a low pass filter, applied to the measured digital code stream, reaches a threshold of N+0.5. In this manner, the processor is determining a time between the digital code N(+0.5) and digital code N+ 1 (+0.5) In some examples, it may be desirable to adjust the timing to reflect group delay in the filter.

In some examples, it may be desirable to use a histogram to determine the length of time at which corresponding ones of the digital codes are observed. A histogram may be created that records how often each ADC digital code is observed for each battery cell. Battery cells with a fast self-discharge rate will have more observed codes in their histogram, but those codes will be observed less often. Conversely, a slowly self-discharging battery cell will have few observed codes, but each of those codes will be observed many times.

The processor circuit 106 may observe the output of an ADC circuit, such as the ADC circuit 104A, and determine how long particular ones of the digital codes DOUT1 remain by counting how often the digital codes occur. For example, the processor circuit 106 may store a count in a histogram bin, where the count represents a number of occurrences of corresponding ones of the digital codes. Then, the processor circuit 106 may determine the length of time at which the corresponding ones of the digital codes remain using a sampling rate of the ADC circuit and the count.

By way of a non-limiting specific example, each time that the processor circuit 106 receives a digital code from the ADC circuit 104A, the processor circuit 106 may store a count in a histogram bin in the memory circuit 107. For example, the processor circuit 106 may receive a first 4-bit digital code of 0111 200 times before the output of the ADC circuit 104A changes (decreases) to a second 4-bit digital code of 0110, for example. After each time it receives the first 4-bit digital code of 0111, the processor 106 may store the count in a histogram bin in the memory circuit 107. For a sampling rate of 100 samples per second (sps), the processor 106 may determine that the first digital code of 0111 remained for 2 seconds. In this manner, the processor circuit 106 may determine a time associated with a particular code and then determine the self-discharge rate of the at least one battery cell using the determined time.

Low pass filtering, applied to the output of an ADC that has noise at its input, may allow some interpolation between the thresholds set by the LSBs of the ADC. However, the interpolated results may have some sub-LSB error patterns. The techniques described above with respect to FIG. 4, where the mean or median times that the ADC LSBs are observed are used to calculate cell voltages as a function of time, may have improved tolerance of any sub-LSB error patterns.

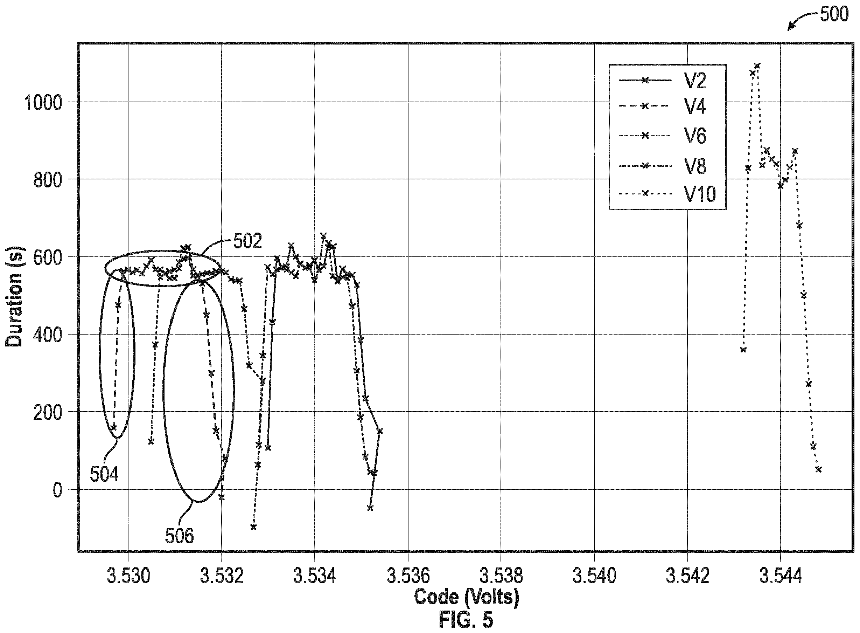

For various reasons, it is possible that the processor circuit may receive outlier digital codes. It may be desirable to remove any outlier digital codes beforehand to more accurately determine the self-discharge rate of the battery cell(s) more accurately. An example of an outlier removal technique is described below with respect to FIG. 5.

FIG. 5 is a graph that depicts the plots in FIG. 4 after using an outlier rejection technique. The graph 500 depicts the cell voltages for the five (5) battery cells (V2, V4, V6, V8, and V10) of FIG. 2, in particular the top envelope waveforms. The x-axis depicts the digital code in volts and the y-axis depicts the duration in seconds.

The plots in the graph 500 may be formed by differentiating the smooth curves in FIG. 4 and then making a histogram of those points. In the graph 500, the distributions are relatively flat on the top and steep on the sides. For example, the battery cell V4 are relatively flat on the top, as shown at 502, and steep on the sides, as shown at 504 and 506. The flatness on the top corresponds to the substantially constant slope of the curve in FIG. 4 and the steep sides correspond to the ends of the curve where the slope is changing.

In the relatively flat portions, such as in portion 502, there are a few outlier data points. The processor circuit 106 may implement an outlier rejection technique, such as a rank order filter or a median filter, to reject these outliers.

In some examples, unreliable digital codes may be known a-priori and the processor circuit 106 may reject those specific digital codes. For example, in some ADC architectures, digital codes at major carries may be unreliable. For instance, hexadecimal code 0FFF, 1FFF, 2FFF, etc. on may be unreliable in many successive approximation register (SAR) ADCs. In this manner, the outlier rejection technique may include ignoring specific digital codes. In some examples, it may be desirable to discharge past those digital codes before discharge measurements are performed.

In this manner, the processor circuit 106 may determine the self-discharge rate of one or more battery cells using the determined duration between the mean times of the consecutive codes from a result of an outlier rejection technique.

For any of the techniques described above, a processor, such the processor circuit 106, may be configured to control operation of a switching element to increase a rate at which the corresponding battery cell discharges. With respect to the outlier rejection techniques of FIG. 5, it may be advantageous to increase a rate at which the battery cell discharges because the number of digital codes generated by the ADC circuit may increase, which may assist in outlier rejection.

For example, assume that it may take 10 hours to detect leakage, as that is how long it takes the leakage current to discharge the cell voltage by 1LSB. This time may be reduced if additional discharge current, or bleed current, is provided through the switching elements, such as switching elements SW1-SW4 in FIG. 1, such as by using a pulsed pattern. If the bleed current is set at four times the leakage current threshold, then a first non-leaky battery cell may discharge at a rate of 1LSB every 2.5 hours, and a second battery cells with the threshold level of leakage may discharge at a rate of 1LSB every 2 hours. In this manner, a processor circuit may determine a first self-discharge rate of the first battery cell and a second self-discharge rate of the second battery cell and then determine a relative self-discharge rate between the first battery cell and the second battery cell. As such, these techniques may detect anomalous battery cells within a battery module that is being monitored by the BMS system.

In some examples, the processor circuit may compare discharge rates of adjacent battery cells to determine which battery cell self-discharge fastest. For example, if battery cell number 3 is discharging faster than its neighbors, then the system may determine that battery cell number 3 is leaky and may calculate the amount of that leakage.

It should be noted that these techniques to accelerate the self-discharge of the battery cells may be applied to any of the techniques described in this disclosure. For example, the techniques described above with respect to mean and median times and FIG. 4 may be combined with the accelerated self-discharge techniques.

The speed-up arising from the addition of bleed current may also be used to count through more than just one LSB crossing when determining a self-discharge rate, such as due to leakage current, with a corresponding increase in detection time. This has the advantage that mean and median filtering of the per-LSB discharge rate measurements may be used to minimize the impact of errors associated with any individual measurement.

As mentioned above, in some examples, the bleed current may be controlled using a pulsed pattern by controlling the operation of the switching elements. If the bleed current is being modulated using a pulsed pattern, then there will effectively be two measured voltages for each battery cell at a given state of charge. One voltage will be measured when its switching element is closed (first state), and another voltage when its switching element is open (second state). The techniques described above may be applied to either of those two states separately, or to the average voltage of the two states. This choice may be used to select the state with the most convenient time alignment.

In leakage detection, the discharge rate is the ratio of the leakage current divided by the incremental capacitance of the battery cell. It is not directly possible to distinguish between the two factors. However, by modulating the additional bleed current, it is possible to distinguish between leakage current and variation in incremental capacitance. For instance, if doubling the bleed current doubles the discharge rate, then the leakage current is zero. On the other hand, if doubling the bleed current increases the discharge rate by only 50%, then the leakage current is equal to the original bleed current.

Any of the techniques described above may be used to determine the self-discharge rate of one or more battery cells using the determined length of time at which corresponding ones of the digital codes remain or linger, which in some examples may include determining a current leakage rate of the battery cell.

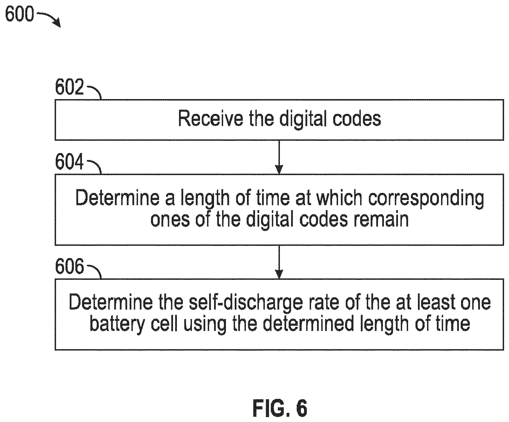

FIG. 6 is a flow diagram of an example of a method 600 of determining a self-discharge rate of at least one battery cell coupled to an analog-to-digital converter (ADC) circuit, where the ADC circuit is configured to receive an analog input signal representing a voltage of the at least one battery cell and generate digital codes representing the analog input signal at corresponding time intervals. At block 602, the method 600 includes receiving the digital codes. For example, the processor circuit 106 or the battery management control circuit 110 can receive the digital codes.

At block 604, the method 600 includes determining a length of time at which corresponding ones of the digital codes remain. For example, the processor circuit 106 or the battery management control circuit 110 can determine a length of time at which corresponding ones of the digital codes remain.

At block 604, the method 600 includes determining the self-discharge rate of the at least one battery cell using the determined length of time. For example, the processor circuit 106 or the battery management control circuit 110 can determine the self-discharge rate of the at least one battery cell using the determined length of time.

In some examples, the method 600 includes performing, before determining the length of time at which corresponding ones of the digital codes remain, time averaging of the received digital codes to determine an average time at which corresponding ones of the digital codes were received.

In some examples, the method 600 includes for the plurality of digital codes, determining a mean or median time at which each digital code was received, wherein determining the self-discharge rate of the at least one battery cell using the determined length of time includes: determining the self-discharge rate of the at least one battery cell using the determined mean or median times.

In some examples, determining, using the plurality of the digital codes, the length of time at which corresponding ones of the digital codes remain includes: for the plurality of digital codes, determining a mean or median time at which each digital code was received; and determining a duration between corresponding mean or median times of consecutive codes, wherein determining the self-discharge rate of the at least one battery cell using the determined length of time includes: determining the self-discharge rate of the at least one battery cell using the determined duration between the corresponding mean or median times of the consecutive codes.

In some examples, the method 600 includes controlling, using a pulsed pattern, a switching element to switch between an open state and a closed state.

In some examples, the method 600 includes storing a count in a histogram bin, wherein the count represents a number of occurrences of the corresponding ones of the digital codes; and determining the length of time at which the corresponding ones of the digital codes remain using a sampling rate of the ADC circuit and the count.

In some examples, determining the self-discharge rate of the at least one battery cell using the determined length of time includes determining a leakage rate of the at least one battery cell.

In some examples, the at least one battery cell includes a first battery cell and a second battery cell, determining the self-discharge rate of the at least one battery cell using the determined length of time includes: determining a first self-discharge rate of the first battery cell and a second self-discharge rate of the second battery cell, and the method 600 further comprises: determining a relative self-discharge rate between the first battery cell and the second battery cell.

### Various Notes

Each of the non-limiting aspects or examples described herein may stand on its own, or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following aspects, the terms "including" and "comprising" are open-ended, that is, a system, device, article, composition, formulation, or process that includes elements in addition to those listed after such a term in an aspect are still deemed to fall within the scope of that aspect. Moreover, in the following aspects, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or nonvolatile tangible computer-readable media, such as during execution or at other times. Examples of these tangible computer-readable media may include, but are not limited to, hard disks, removable magnetic disks, removable optical disks (e.g., compact discs and digital video discs), magnetic cassettes, memory cards or sticks, random access memories (RAMs), read only memories (ROMs), and the like.

The above description is intended to be illustrative, and not restrictive.

## Claims

1. A battery management system configured to determine a self-discharge rate of at least one battery cell, the battery management system comprising:
an analog-to-digital converter, ADC (104A-104D), ADO, circuit coupled to the at least one battery cell (100A-100D) and configured to receive an analog input signal representing a voltage of the at least one battery cell and generate digital codes representing the analog input signal at corresponding time intervals; **characterised in that** the battery management system further comprising
a processor (106) configured to:
receive the digital codes;
determine a length of time at which corresponding ones of the digital codes remain; and
determine the self-discharge rate of the at least one battery cell using the determined length of time.

2. The battery management system of claim 1, wherein the processor is configured to:
perform, before determining the length of time at which corresponding ones of the digital codes remain, time averaging of the received digital codes to determine an average time at which corresponding ones of the digital codes were received.

3. The battery management system of claim 1 or 2, wherein the processor is configured to:
perform a linear regression technique of the received digital codes and the determined lengths of time to determine the self-discharge rate.

4. The battery management system of any preceding claim, wherein the processor configured to determine, using the plurality of the digital codes, the length of time at which corresponding ones of the digital codes remain includes:
for the plurality of digital codes, determine a mean or median time at which each digital code was received; and
determine a duration between corresponding mean or median times of consecutive codes,
wherein the processor configured to determine the self-discharge rate of the at least one battery cell using the determined length of time is configured to:
determine the self-discharge rate of the at least one battery cell using the determined duration between the corresponding mean or median times of the consecutive codes.

5. The battery management system of any preceding claim, comprising:
a resistor (RS1-RS4) coupled in series with a switching element (SW1-SW4), the resistor and switching element coupled in parallel across one of the battery cells,
wherein the processor is configured to control operation of the switching element to increase a rate at which the battery cell discharges.

6. The battery management system of claim 5, wherein the processor is configured to:
control, using a pulsed pattern, the switching element to switch between an open state and a closed state.

7. The battery management system of claim 6, wherein the processor is configured to, when the switching element is in the open state and/or when the switching element is in the closed state:
receive the digital codes;
determine the length of time at which corresponding ones of the digital codes remain; and
determine the self-discharge rate of the at least one battery cell using the determined length of time.

8. The battery management system of any of claims 5 to 7, wherein the processor configured to determine the self-discharge rate of the at least one battery cell using the determined duration between the mean times of the consecutive codes is configured to:
determine the self-discharge rate of the at least one battery cell using the determined duration between the mean times of the consecutive codes from a result of an outlier rejection technique, preferably wherein the outlier rejection technique includes ignoring specific digital codes.

9. The battery management system of any preceding claim, wherein the processor configured to determine the self-discharge rate of the at least one battery cell using the determined length of time is configured to determine a leakage rate of the at least one battery cell.

10. The battery management system of any preceding claim, wherein the at least one battery cell includes a first battery cell and a second battery cell, wherein the processor configured determine the self-discharge rate of the at least one battery cell using the determined length of time is configured to:
determine a first self-discharge rate of the first battery cell and a second self-discharge rate of the second battery cell, and wherein the processor is further configured to:
determine a relative self-discharge rate between the first battery cell and the second battery cell.

11. The battery management system of any preceding claim, wherein the processor is a battery management control circuit.

12. A method of determining a self-discharge rate of at least one battery cell coupled to an analog-to-digital converter, ADC, circuit, wherein the ADC circuit is configured to receive an analog input signal representing a voltage of the at least one battery cell and generate digital codes representing the analog input signal at corresponding time intervals, the method is **characterised by**:
receiving (602) the digital codes;
determining (604) a length of time at which corresponding ones of the digital codes remain; and
determining (606) the self-discharge rate of the at least one battery cell using the determined length of time.

13. The method of claim 12, comprising:
performing, before determining the length of time at which corresponding ones of the digital codes remain, time averaging of the received digital codes to determine an average time at which corresponding ones of the digital codes were received.

14. The method of claim 12 or 13, comprising:
wherein determining, using the plurality of the digital codes, the length of time at which corresponding ones of the digital codes remain includes:
for the plurality of digital codes, determining a mean or median time at which each digital code was received; and preferably determining a duration between corresponding mean or median times of consecutive codes,
wherein determining the self-discharge rate of the at least one battery cell using the determined length of time includes:
determining the self-discharge rate of the at least one battery cell using the determined mean or median times, preferably determining the self-discharge rate of the at least one battery cell using the determined duration between the corresponding mean or median times of the consecutive codes.

15. The method of any of claims 12 to 14, comprising:
controlling, using a pulsed pattern, a switching element to switch between an open state and a closed state.

## Patentansprüche

1. Batteriemanagementsystem, das konfiguriert ist, eine Selbstentladungsrate mindestens einer Batteriezelle zu bestimmen, wobei das Batteriemanagementsystem Folgendes umfasst:
eine Analog/Digital-Umsetzerschaltung, ADC-Schaltung (104A-104D), die an die mindestens eine Batteriezelle (100A-100D) gekoppelt ist und konfiguriert ist, ein analoges Eingangssignal zu empfangen, das eine Spannung der mindestens einen Batteriezelle repräsentiert, und digitale Codes zu erzeugen, die das analoge Eingangssignal in entsprechenden Zeitintervallen repräsentieren;
**dadurch gekennzeichnet, dass** das Batteriemanagementsystem ferner einen Prozessor (1060) umfasst, der konfiguriert ist zum:
Empfangen der digitalen Codes;
Bestimmen einer Zeitdauer, in der entsprechende der digitalen Codes verbleiben; und
Bestimmen der Selbstentladungsrate der mindestens einen Batteriezelle unter Verwendung der bestimmten Zeitdauer.

2. Batteriemanagementsystem nach Anspruch 1, wobei der Prozessor konfiguriert ist zum:
Durchführen vor dem Bestimmen der Zeitdauer, zu der entsprechende der digitalen Codes verbleiben, einer zeitlichen Mittelung der empfangenen digitalen Codes, um eine durchschnittliche Zeit zu bestimmen, zu der entsprechende der digitalen Codes empfangen wurden.

3. Batteriemanagementsystem nach Anspruch 1 oder 2, wobei der Prozessor konfiguriert ist zum:
Durchführen einer linearen Regressionstechnik der empfangenen digitalen Codes und der bestimmten Zeitdauern, um die Selbstentladungsrate zu bestimmen.

4. Batteriemanagementsystem nach einem vorhergehenden Anspruch, wobei die Konfiguration des Prozessors, unter Verwendung der mehreren digitalen Codes die Zeitdauer zu bestimmen, in der entsprechende der digitalen Codes verbleiben, Folgendes umfasst:
Bestimmen für die mehreren digitalen Codes einer Mittelwert- oder Medianzeit, zu der jeder digitale Code empfangen wurde; und
Bestimmen einer Dauer zwischen entsprechenden Mittelwert- oder Medianzeiten aufeinanderfolgender Codes,
wobei der Prozessor, der konfiguriert ist, die Selbstentladungsrate der mindestens einen Batteriezelle unter Verwendung der bestimmten Zeitdauer zu bestimmen, konfiguriert ist zum:
Bestimmen der Selbstentladungsrate der mindestens einen Batteriezelle unter Verwendung der bestimmten Dauer zwischen den entsprechenden Mittelwert- oder Medianzeiten der aufeinanderfolgenden Codes.

5. Batteriemanagementsystem nach einem vorhergehenden Anspruch, das Folgendes umfasst:
einen Widerstand (RS1-RS4), der mit einem Schaltelement (SW1-SW4) in Reihe geschaltet ist, wobei der Widerstand und das Schaltelement über eine der Batteriezellen parallelgeschaltet sind,
wobei der Prozessor konfiguriert ist, eine Betätigung des Schaltelements zu steuern, um eine Rate zu erhöhen, bei der die Batteriezelle entladen wird.

6. Batteriemanagementsystem nach Anspruch 5, wobei der Prozessor konfiguriert ist zum:
Steuern unter Verwendung eines gepulsten Musters des Schaltelements, zwischen einem offenen Zustand und einem geschlossenen Zustand umzuschalten.

7. Batteriemanagementsystem nach Anspruch 6, wobei der Prozessor dann, wenn das Schaltelement im offenen Zustand ist und/oder wenn das Schaltelement im geschlossenen Zustand ist, konfiguriert ist zum:
Empfangen der digitalen Codes;
Bestimmen der Zeitdauer, zu der entsprechende der digitalen Codes verbleiben; und
Bestimmen der Selbstentladungsrate der mindestens einen Batteriezelle unter Verwendung der bestimmten Zeitdauer.

8. Batteriemanagementsystem nach einem der Ansprüche 5 bis 7, wobei der Prozessor, der konfiguriert ist, die Selbstentladungsrate der mindestens einen Batteriezelle unter Verwendung der bestimmten Dauer zwischen den durchschnittlichen Zeiten der aufeinanderfolgenden Codes zu bestimmen, konfiguriert ist zum:
Bestimmen der Selbstentladungsrate der mindestens einen Batteriezelle unter Verwendung der bestimmten Dauer zwischen den durchschnittlichen Zeiten der aufeinanderfolgenden Codes aus einem Ergebnis einer Ausreißerablehnungstechnik, wobei bevorzugt die Ausreißerablehnungstechnik ein Ignorieren bestimmter digitaler Codes enthält.

9. Batteriemanagementsystem nach einem vorhergehenden Anspruch, wobei der Prozessor, der konfiguriert ist, die Selbstentladungsrate der mindestens einen Batteriezelle unter Verwendung der bestimmten Zeitdauer zu bestimmen, konfiguriert ist, eine Leckrate der mindestens einen Batteriezelle zu bestimmen.

10. Batteriemanagementsystem nach einem vorhergehenden Anspruch, wobei die mindestens eine Batteriezelle eine erste Batteriezelle und eine zweite Batteriezelle enthält und der Prozessor, der konfiguriert ist, die Selbstentladungsrate der mindestens einen Batteriezelle unter Verwendung der bestimmten Zeitdauer zu bestimmen, konfiguriert ist zum:
Bestimmen einer ersten Selbstentladungsrate der ersten Batteriezelle und einer zweiten Selbstentladungsrate der zweiten Batteriezelle, wobei der Prozessor ferner konfiguriert ist zum:
Bestimmen einer relativen Selbstentladungsrate zwischen der ersten Batteriezelle und der zweiten Batteriezelle.

11. Batteriemanagementsystem nach einem vorhergehenden Anspruch, wobei der Prozessor eine Batteriemanagementsteuerschaltung ist.

12. Verfahren zum Bestimmen einer Selbstentladungsrate mindestens einer Batteriezelle, die an eine Analog/Digital-Umsetzerschaltung, ADC-Schaltung, gekoppelt ist, wobei die ADC-Schaltung konfiguriert ist, ein analoges Eingangssignal zu empfangen, das eine Spannung der mindestens einen Batteriezelle repräsentiert, und digitale Codes zu erzeugen, die das analoge Eingangssignal in entsprechenden Zeitintervallen repräsentieren, und das Verfahren **gekennzeichnet ist durch**:
Empfangen (602) der digitalen Codes;
Bestimmen (604) einer Zeitdauer, zu der entsprechende der digitalen Codes verbleiben; und
Bestimmen (600) der Selbstentladungsrate der mindestens einen Batteriezelle unter Verwendung der bestimmten Zeitdauer.

13. Verfahren nach Anspruch 12, das Folgendes umfasst:
Durchführen vor dem Bestimmen der Zeitdauer, zu der entsprechende der digitalen Codes verbleiben, einer zeitlichen Mittelung der empfangenen digitalen Codes, um eine durchschnittliche Zeit zu bestimmen, in der entsprechende der digitalen Codes empfangen wurden.

14. Verfahren nach Anspruch 12 oder 13, das Folgendes umfasst:
wobei das Bestimmen unter Verwendung der mehreren digitalen Codes der Zeitdauer, zu der entsprechende der digitalen Codes verbleiben, Folgendes umfasst:
für die mehreren digitalen Codes Bestimmen einer Mittelwert- oder Medianzeit, in der jeder digitale Code empfangen wurde; und bevorzugt Bestimmen einer Dauer zwischen entsprechenden Mittelwert- oder Medianzeiten aufeinanderfolgender Codes,
wobei das Bestimmen der Selbstentladungsrate der mindestens einen Batteriezelle unter Verwendung der bestimmten Zeitdauer Folgendes umfasst:
Bestimmen der Selbstentladungsrate der mindestens einen Batteriezelle unter Verwendung der bestimmten Mittelwert- oder Medianzeiten und bevorzugt Bestimmen der Selbstentladungsrate der mindestens einen Batteriezelle unter Verwendung der bestimmten Dauer zwischen den entsprechenden Mittelwert- oder Medianzeiten der aufeinanderfolgenden Codes.

15. Verfahren nach einem der Ansprüche 12 bis 14, das Folgendes umfasst:
Steuern unter Verwendung eines gepulsten Musters eines Schaltelements, zwischen einem offenen Zustand und einem geschlossenen Zustand umzuschalten.

## Revendications

1. Système de gestion de batterie configuré pour déterminer un taux d'auto-décharge d'au moins un élément de batterie, le système de gestion de batterie comprenant :
un circuit de convertisseur analogique-numérique, CAN (104A-104D), couplé au au moins un élément de batterie (100A-100D) et configuré pour recevoir un signal d'entrée analogique représentant une tension du au moins un élément de batterie et générer des codes numériques représentant le signal d'entrée analogique à des intervalles de temps correspondants ;
**caractérisé en ce que** le système de gestion de batterie comprend en outre
un processeur (106) configuré pour :
recevoir les codes numériques ;
déterminer une durée pendant laquelle certains correspondants des codes numériques subsistent ; et
déterminer le taux d'auto-décharge du au moins un élément de batterie en utilisant la durée déterminée.

2. Système de gestion de batterie selon la revendication 1, dans lequel le processeur est configuré pour :
effectuer, avant de déterminer la durée pendant laquelle certains correspondants des codes numériques subsistent, un moyennage temporel des codes numériques reçus pour déterminer un temps moyen auquel certains correspondants des codes numériques ont été reçus.

3. Système de gestion de batterie selon la revendication 1 ou 2, dans lequel le processeur est configuré pour :
effectuer une technique de régression linéaire des codes numériques reçus et des durées déterminées pour déterminer le taux d'auto-décharge.

4. Système de gestion de batterie selon l'une quelconque des revendications précédentes, dans lequel le processeur configuré pour déterminer, en utilisant la pluralité des codes numériques, la durée pendant laquelle certains correspondants des codes numériques subsistent inclut les étapes consistant à :
pour la pluralité de codes numériques, déterminer un temps moyen ou médian auquel chaque code numérique a été reçu ; et
déterminer une durée entre les temps moyens ou médians correspondants de codes consécutifs,
dans lequel le processeur configuré pour déterminer le taux d'auto-décharge du au moins un élément de batterie en utilisant la durée déterminée est configuré pour :
déterminer le taux d'auto-décharge du au moins un élément de batterie en utilisant la durée déterminée entre les temps moyens ou médians correspondants des codes consécutifs.

5. Système de gestion de batterie selon l'une quelconque des revendications précédentes, comprenant : une résistance (RS1-RS4) couplée en série avec un élément de commutation (SW1-SW4), la résistance et l'élément de commutation étant couplés en parallèle à travers l'un des éléments de batterie,
dans lequel le processeur est configuré pour commander le fonctionnement de l'élément de commutation pour augmenter une vitesse à laquelle l'élément de batterie se décharge.

6. Système de gestion de batterie selon la revendication 5, dans lequel le processeur est configuré pour :
commander, en utilisant un motif pulsé, l'élément de commutation pour commuter entre un état ouvert et un état fermé.

7. Système de gestion de batterie selon la revendication 6, dans lequel le processeur est configuré pour, lorsque l'élément de commutation est dans l'état ouvert et/ou lorsque l'élément de commutation est dans l'état fermé :
recevoir les codes numériques ;
déterminer la durée pendant laquelle certains correspondants des codes numériques subsistent ; et
déterminer le taux d'auto-décharge du au moins un élément de batterie en utilisant la durée déterminée.

8. Système de gestion de batterie selon l'une quelconque des revendications 5 à 7, dans lequel le processeur configuré pour déterminer le taux d'auto-décharge du au moins un élément de batterie en utilisant la durée déterminée entre les temps moyens des codes consécutifs est configuré pour :
déterminer le taux d'auto-décharge du au moins un élément de batterie en utilisant la durée déterminée entre les temps moyens des codes consécutifs à partir d'un résultat d'une technique de rejet de valeurs aberrantes, de préférence dans lequel la technique de rejet de valeurs aberrantes inclut l'ignorance de codes numériques spécifiques.

9. Système de gestion de batterie selon l'une quelconque des revendications précédentes, dans lequel le processeur configuré pour déterminer le taux d'auto-décharge d'au moins un élément de batterie en utilisant la durée déterminée est configuré pour déterminer un taux de fuite du au moins un élément de batterie.

10. Système de gestion de batterie selon l'une quelconque des revendications précédentes, dans lequel le au moins un élément de batterie inclut un premier élément de batterie et un second élément de batterie, dans lequel le processeur configuré pour déterminer le taux d'auto-décharge du au moins un élément de batterie en utilisant la durée déterminée est configuré pour :
déterminer un premier taux d'auto-décharge du premier élément de batterie et un second taux d'auto-décharge du second élément de batterie, et dans lequel le processeur est en outre configuré pour :
déterminer un taux d'auto-décharge relatif entre le premier élément de batterie et le second élément de batterie.

11. Système de gestion de batterie selon l'une quelconque des revendications précédentes, dans lequel le processeur est un circuit de commande de gestion de batterie.

12. Procédé de détermination d'un taux d'auto-décharge d'au moins un élément de batterie couplé à un circuit de convertisseur analogique-numérique, CAN, dans lequel le circuit CAN est configuré pour recevoir un signal d'entrée analogique représentant une tension du au moins un élément de batterie et générer des codes numériques représentant le signal d'entrée analogique à des intervalles de temps correspondants, le procédé étant **caractérisé par** les étapes consistant à :
recevoir (602) les codes numériques ;
déterminer (604) une durée pendant laquelle certains correspondants des codes numériques subsistent ; et
déterminer (606) le taux d'auto-décharge du au moins un élément de batterie en utilisant la durée déterminée.

13. Procédé selon la revendication 12, comprenant en outre l'étape consistant à :
effectuer, avant de déterminer la durée pendant laquelle certains correspondants des codes numériques subsistent, un moyennage temporel des codes numériques reçus pour déterminer un temps moyen auquel certains correspondants des codes numériques ont été reçus.

14. Procédé selon la revendication 12 ou 13, comprenant :
dans lequel la détermination, en utilisant la pluralité des codes numériques, de la durée pendant laquelle certains correspondants des codes numériques subsistent inclut les étapes consistant à :
pour la pluralité de codes numériques, déterminer un temps moyen ou médian auquel chaque code numérique a été reçu ; et de préférence déterminer une durée entre les temps moyens ou médians correspondants de codes consécutifs,
dans lequel, la détermination du taux d'auto-décharge du au moins un élément de batterie en utilisant la durée déterminée inclut les étapes consistant à :
déterminer le taux d'auto-décharge du au moins un élément de batterie à l'aide des temps moyens ou médians déterminés, de préférence déterminer le taux d'auto-décharge du au moins un élément de batterie à l'aide due la durée déterminée entre les temps moyens ou médians correspondants des codes consécutifs.

15. Procédé selon l'une quelconque des revendications 12 à 14, comprenant l'étape consistant à :
commander, en utilisant un motif pulsé, un élément de commutation pour commuter entre un état ouvert et un état fermé.
